# EUROPÄISCHE PATENTSCHRIFT

(11) **EP 1 788 707 B1**
(45) Veröffentlichungstag und Bekanntmachung des Hinweises auf die Patenterteilung: **24.03.2010**
(21) Anmeldenummer: 06022606.5
(22) Anmeldetag: 30.10.2006
(51) Int. Cl.: H03M 1/12, H04L 7/02, H04L 7/033

(54) **Verfahren zum Einstellen von Abtast-Zeitpunkten eines Abtasttakts in einem Bildsignal-Abtastsystem bzw. Schaltung zum Durchführen eines solchen Verfahrens**
Method of setting sampling times of a sample clock in an image signal sampling system & circuit for carrying out same.
Procédé et circuit pour régler les points d'échantillonnage par un signal d'horloge dans un système d'échantillonnage de signaux d'image.

(30) Priorität: 18.11.2005 DE 102005055543
(43) Veröffentlichungstag der Anmeldung: 23.05.2007
(73) Patentinhaber: Micronas GmbH, 79108 Freiburg i. Br. (DE)
(72) Erfinder: Waldner, Markus, 9020 Klagenfurt (AT)
(74) Vertreter: Göhring, Robert

(56) Entgegenhaltungen:
- EP-A2- 0 845 865
- US-A- 5 255 289
- US-A- 5 991 346

## Beschreibung

Die Erfindung bezieht sich auf ein Verfahren zum Einstellen von Abtast-Zeitpunkten eines Abtasttakts in einem Bildsignal-Abtastsystem mit den oberbegrifflichen Merkmalen des Patentanspruchs 1 bzw. auf eine Schaltung zum Durchführen eines derartigen Verfahrens gemäß dem Oberbegriff des Anspruchs 13.

Zum Durchführen eines solchen Verfahrens wird ein analoges Bildsignal von einer Bildsignal-Quelle bereitgestellt und mittels eines Abtasttakts, welcher eine feste Abtast-Frequenz aufweist, abgetastet. Der Abtasttakt wird durch eine zeitliche Verschiebung aus einem Basistakt, welcher eine feste Basistakt-Frequenz hat, gewonnen und zum Abtasten des analogen Bildsignals bereitgestellt. Die erforderliche Verschiebung wird mittels eines Regelverfahrens und üblicherweise einer phasengekoppelten Verzögerungsschleife aus den Bilddaten bestimmt. Derart durch Abtasten gewonnene digitale Bilddaten werden einem Datenausgang zur weiteren Verarbeitung oder Ausgabe zugeführt.

Ein idealer Abtast-Zeitpunkt bei einem analogen Signal, welches von beispielsweise einer Grafikkarte in einem Computer geliefert wird, befindet sich dort, wo die einzelnen Bildpunkte bzw. Pixel im Signal ihr Plateau haben. Um sogenannten Takt- bzw. Clock Jitter in einem mittels der digitalen Daten dargestellten Bild nicht sichtbar werden zu lassen, sollte das Plateau beim Abtasten möglichst genau in der Mitte getroffen werden. Problematisch ist dabei, dass die Übergänge von einem Bildpunkt zum nächsten jedoch relativ schmal und damit schwer erfassbar sind. Werden die Bildpunkte beim Abtasten des analogen Signals nicht im Plateau sondern eher in den Übergängen getroffen, dann wird das Bild sehr unscharf und man kann bei feinen Bildstrukturen Moiree-Muster erkennen, welche ihre Ursache im Clock-Jitter haben. ben.

Um die Abtast-Zeitpunkte eines Abtasttakts möglichst genau in die Mitte zu regeln, werden unter anderem statistische Verfahren verwendet. Nachteilhaft bei statistischen Methoden ist, dass diese von Natur aus sehr langsam sind, da sie immer eine sehr große Menge von Daten benötigen und verarbeiten müssen. Bei einem Verfahren und einer Vorrichtung zur Rekonstruktion und Regelung der Phasenlage eines Abtasttaktes bezüglich eines abzutastenden analogen Signals gemäß DE 10 2004 027 093 ist nachteilhaft, dass ein analoges Schaltungselement erforderlich ist, welches eine Information über einen Signalgradienten zum Abtast-Zeitpunkt liefert, so dass keine üblichen AD-Wandler (AD: Analog/Digital) verwendet werden können.

Als weiterer Stand der Technik wird die US 5,255,289 A genannt.

Die Aufgabe der Erfindung besteht darin, ein alternatives Verfahren zum Einstellen von Abtast-Zeitpunkten eines Abtasttaktes in einem Bildsignal-Abtastsystem zum Bereitstellen eines digitalen Bildsignals aus einem analogen Bildsignal vorzuschlagen, wobei ein solches Verfahren vorzugsweise bei geringem Schaltungsaufwand und geringem Rechenaufwand einen möglichst optimalen Abtast-Zeitpunkt einstellen soll.

Diese Aufgabe wird gelöst durch ein Verfahren zum Einstellen von Abtast-Zeitpunkten eines Abtasttakts in einem Bildsignal-Abtastsystem mit den oberbegrifflichen Merkmalen des Patentanspruchs 1. Eine Schaltung zum Durchführen eines solchen Verfahrens ist ausgebildet gemäß den Merkmalen des Patentanspruchs 13. Vorteilhafte Ausgestaltungen sind Gegenstand von abhängigen Ansprüchen.

Bevorzugt wird demgemäß ein Verfahren zum Einstellen von Abtast-Zeitpunkten eines Abtasttakts in einem Bildsignal-Abtastsystem, bei dem ein analoges Bildsignal bereitgestellt und mittels des Abtasttakts mit einer Abtast-Frequenz zum Bereitstellen digitaler Bilddaten abgetastet wird, wobei der Abtasttakt durch zeitliche Verschiebung aus einem Basistakt zum Abtasten bereitgestellt wird und eine erforderliche zeitliche Verschiebung bestimmt wird aus den Bilddaten, wobei eine Folge von Amplituden-Differenzen zwischen jeweils zumindest zwei Amplitudenwerten der Bilddaten ermittelt wird, ein Minimum-Abtast-Zeitpunkt als Zeitpunkt der geringsten Amplituden-Differenz aus der Folge der Amplituden-Differenzen bestimmt wird und die zum Abtasten zu verwendenden Abtast-Zeitpunkte bestimmt werden aus dem Minimum-Abtast-Zeitpunkt zuzüglich der erforderlichen zeitlichen Verschiebung ungleich Null.

Vorteilhaft ist ein solches Verfahren, bei dem als Wert der erforderlichen zeitlichen Verschiebung ein Wert zwischen 1/3 und 2/3 einer Periode der Abtast-Frequenz verwendet wird, insbesondere als Wert der erforderlichen zeitlichen Verschiebung ein Wert von etwa 1/2 einer Periode, insbesondere genau 1/2 einer Periode der Abtast-Frequenz verwendet wird.

Vorteilhaft ist ein solches Verfahren, bei dem zur Bestimmung des Minimum-Abtast-Zeitpunktes eine Mittelung über zueinander benachbarte Amplituden-Differenzen durchgeführt wird. Vorteilhaft ist ein solches Verfahren, bei dem die Verschiebung derart bestimmt wird, dass die Abtast-Zeitpunkte des Abtasttakts in einen Plateaubereich eines Bildpunktes fallen. Vorteilhaft ist ein solches Verfahren, bei dem die Bilddaten vor dem Bestimmen des Minimum-Abtast-Zeitpunkts gefiltert werden, insbesondere mit einem Medianfilter und einem Tiefpassfilter gefiltert werden. Vorteilhaft ist ein solches Verfahren, bei dem die Abtast-Frequenz gleich oder gleich einem gerad- und ganzzahligen Vielfachen einer Bildfrequenz verwendet wird.

Vorteilhaft ist ein solches Verfahren, bei dem die Amplituden-Differenzen gebildet werden aus jeweils zwei unmittelbar aufeinanderfolgenden Amplitudenwerten der Bilddaten. Vorteilhaft ist ein solches Verfahren, bei dem eine Vielzahl aufeinanderfolgender Amplituden-Differenzen aufsummiert wird. Vorteilhaft ist ein solches Verfahren, bei dem die Amplituden-Differenzen wenigstens einer Zeile, z. B. eine Zeile eines Bildes aufsummiert werden und mit aufsummierten Werten derselben Zeile eines anderen Bildes verglichen werden.

Vorteilhaft ist ein solches Verfahren, bei dem eine Δ-Funktion gebildet wird durch Erfassen eines ersten Differenzwertes als erstem Δ-Funktionswert und durch das jeweilige Verschieben des Abtasttaktes und Erfassen eines weiteren Differenzwertes als weiterem Δ-Funktionswert und bei dem der Minimum-Abtast-Zeitpunkt alternativ oder zusätzlich indirekt aus einem Minimum der Δ-Funktion bestimmt wird. Vorteilhaft ist ein solches Verfahren, bei dem der Minimum-Abtast-Zeitpunkt alternativ oder zusätzlich indirekt bestimmt wird über das Bestimmen eines Maximums einer zweiten Ableitung der Δ-Funktion, wobei die Δ-Funktion aus aufeinanderfolgenden Amplituden-Differenzen gebildet wird.

Vorteilhaft ist außerdem eine Schaltung zum Einstellen von Abtast-Zeitpunkten eines Abtasttakts in einem Bildsignal-Abtastsystem, mit einem AD-Wandler, dem ein analoges Bildsignal bereitgestellt und mittels des Abtasttakts mit einer Abtast-Frequenz zum Bereitstellen digitaler Bilddaten abgetastet wird, wobei Mittel vorgesehen sind, sodass der Abtasttakt durch zeitliche Verschiebung aus einem Basistakt zum Abtasten bereitgestellt wird und Mittel zur Bestimmung einer erforderlichen zeitlichen Verschiebung aus den Bilddaten vorgesehen sind, wobei Mittel zur Ermittlung einer Folge von Amplituden-Differenzen zwischen jeweils zumindest zwei Amplitudenwerten der Bilddaten, Mittel zur Bestimmung eines Minimum-Abtast-Zeitpunkts als Zeitpunkt der geringsten Amplituden-Differenz aus der Folge der Amplituden-Differenzen und Mittel zum Bestimmen der zum Abtasten zu verwendenden Abtast-Zeitpunkte aus dem Minimum-Abtast-Zeitpunkt zuzüglich der erforderlichen zeitlichen Verschiebung ungleich Null, vorgesehen sind.

Vorteilhafter Weise werden verfahrensgemäß keine statistischen Verfahren eingesetzt. Auch eine Information über einen Signalgradienten muss nicht bereitgestellt werden, so dass verfahrensgemäß und schaltungsgemäß ein deutlich geringerer Aufwand besteht. Gelöst wird insbesondere ein Problem bei PC-Anwendungen (PC: Personal-Computer) und generell bei Anwendungen, bei denen ein analoges Signal abgetastet werden muss, das von einer Grafikkarte kommt. Damit ein scharfes Bild mittels der digitalisierten Bilddaten erzeugt werden kann, müssen die einzelnen Bildpunkte beim Abtasten des analogen Signals möglichst genau in der Mitte getroffen werden. Dies wird verfahrensgemäß gewährleistet.

Bevorzugt wird ein Verfahren, bei dem in einem ersten Schritt darauf abgezielt wird, die Pixel-Übergänge zwischen zwei Bild-punkten bzw. Pixeln genau zu treffen, da diese überraschend leicht zu finden sind und einen eindeutigen Wert ergeben. Da die Bildpunktperiode bekannt ist, kann nachfolgend in einem zweiten Schritt die gefundene Phasenlage zum Bilden des idealen Abtast-Zeitpunktes durch Verschieben um vorzugsweise eine halbe Bildpunktperiode verwendet werden. Ausgenutzt wird dabei, dass bei einer Differenzbildung aufeinanderfolgender Abtastwerte ein Differenz-Minimum, welches sich im Bereich von Bildpunktübergängen befindet, besonders eindeutig auffinden lässt. Außerdem wird die Tatsache ausgenutzt, dass die Bildpunktübergänge, welche durch diese Verfahrensweise einfach zu finden sind, um eine halbe Bildperiode gegenüber den idealen Abtast-Zeitpunkten in der Mitte des Bildpunkt-Plateaus versetzt angeordnet sind.

Ein Ausführungsbeispiel wird nachfolgend anhand der Zeichnung näher erläutert. Es zeigen:
- Fig. 1: ein schematisches Diagramm zum Veranschaulichen von Schaltungs-Komponenten und Verfahrensschritten zum Durchführen eines Verfahrens zur Einstellung eines vorzugsweise idealen Abtast-Zeitpunkts bei Bildsignal-Abtastsystemen,
- Fig. 2: schematisch eine Schaltungs-Anordnung zum Durchführen eines bevorzugten Verfahrens,
- Fig. 3: drei Beispiele einer Sinus-Schwingung, welche mit unterschiedlichen Phasenlagen abgetastet wird zur Erläuterung des dem Verfahren zugrundeliegenden Prinzips,
- Fig. 4: einen typischen Verlauf eines Videosignals als einem abzutastenden analogen Bildsignal,
- Fig. 5: Amplituden-Werte eines Eingangssignals sowie Werte einer daraus gebildeten Δ-Funktion,
- Fig. 6: ein beispielhaftes Signal mit Rauschen und Messfehlern sowie daraus gefilterten Werte,
- Fig. 7: eine erste und eine zweite Ableitung einer als Δ-Funktion akkumulierten Folge von Daten und
- Fig. 8: eine weitere beispielhafte Signalfolge und Signalverläufe von Zwischen-Verarbeitungsschritten.

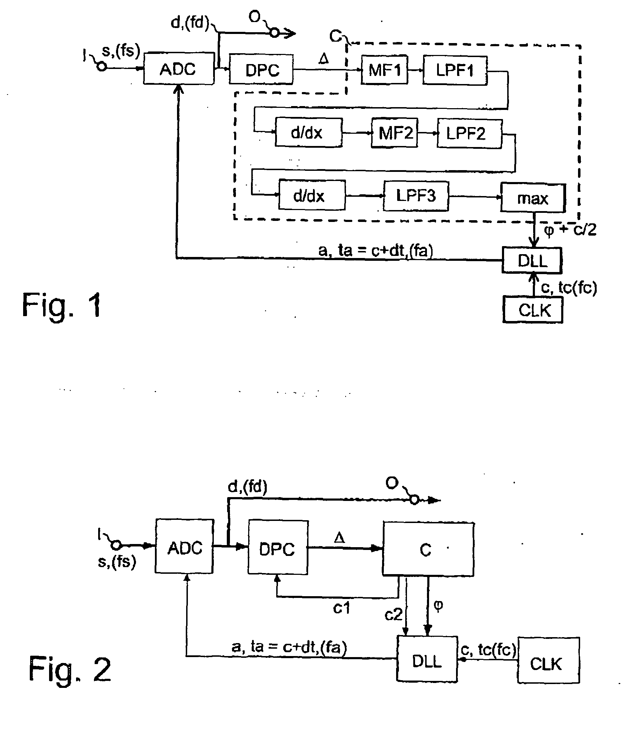

Wie dies aus Fig. 1 ersichtlich ist, wird ein analoges Bildsignal s an einem Eingang I in eine beispielhafte Schaltungs-Anordnung eingegeben. Der Eingang I bildet dabei eine beispielhafte Bildsignal-Quelle aus. Das analoge Bildsignal s wird einem AD-Wandler ADC angelegt, welcher das analoge Bildsignal s zu diskreten Abtast-Zeitpunkten ta eines Abtasttakts a abtastet und digitale Bilddaten d ausgibt. Die digitalen Bilddaten d weisen vorzugsweise eine Bilddaten-Frequenz fd mit der doppelten Frequenz einer Basistakt-Frequenz (fc) eines Basistakts c auf, welcher von einer Taktquelle CLK bereitgestellt wird. Der Abtasttakt a wird aus dem Basistakt c mittels einer Regeleinrichtung durch, sofern erforderlich, eine zeitliche Verschiebung dt der Zeitpunkte tc des Basistakts c bereitgestellt.

Die digitalen Bilddaten d werden außerdem einer Datenphasen-Steuereinrichtung DPC angelegt, welche einen intelligenten Sensor ausbildet, welcher nachfolgend beschriebene Messungen durchführt. Wie dies aus Fig. 1 und 2 ersichtlich ist, bildet die Datenphasen-Steuereinrichtung ein Δ-Signal, welches einer Steuereinrichtung C in Form beispielsweise eines Prozessors angelegt wird. Die Steuereinrichtung C bestimmt neben Steuer- bzw. Kontrollsignalen c1, c2, welche der Datenphasen-Steuereinrichtung DPC und einer eigentlichen Phasen-Regeleinrichtung DLL angelegt werden, auch eine Phasenverschiebung zum Übermitteln einer erforderlichen Korrekturphase oder einer gewünschten Phase ϕ, welche der Phasen-Regeleinrichtung DLL angelegt wird. Die Phasen-Regeleinrichtung DLL wird vorzugsweise durch eine für sich bekannte verzögerungsgekoppelte Schleife (Delay Locked Loop) ausgebildet und erzeugt den Abtasttakt a aus dem Basistakt c.

Gemäß einem besonders bevorzugten Verfahren werden in der Datenphasen-Steuereinrichtung DPC Amplituden-Differenzen aufeinanderfolgender Abtastwerte bzw. digitaler Bilddatenwerte der digital Bilddaten d bestimmt und aufsummiert bzw. akkumuliert, um eine Δ-Funktion aus einer Abfolge aufeinanderfolgender und aufsummierter Differenzwerte bereitzustellen. Diese akkumulierten bzw. aufsummierten Werte werden einem ersten Medianfilter MF1 und nachfolgend einem ersten Tiefpassfilter LPF1 zugeführt. Die derart gefilterten Werte werden einer Ableitungseinrichtung dΔ/dx zum Bilden der ersten Ableitung der Δ-Funktion angelegt. Die derart abgeleiteten Werte werden einem zweiten Medianfilter MF2 und dann einem zweiten Tiefpassfilter LPF2 angelegt, bevor eine weitere Ableitung in einer entsprechenden Ableitungseinrichtung d²Δ/dx² gebildet wird. Die zweifach abgeleiteten Werte der Δ-Funktion werden einem dritten Tiefpassfilter LPF3 angelegt und nach der Filterung einem Algorithmus oder einer Einrichtung zum Suchen eines Maximums max in der Folge der derart bereitgestellten Datenwerte zu suchen.

Der Zeitpunkt des Maximumwerts wird als ein Phasenwert ϕ, dem der Wert einer halben Periode c/2 des Abtasttaktes a bzw. Basistaktes c aufaddiert wird, zur Phasenkorrektur des Abtasttaktes bereitgestellt. Ausgenutzt wird dabei, dass der Maximumwert der zweifach abgeleiteten Δ-Funktion einem Minimumwert der Δ-Funktion selber bzw. einem Minimumwert einer Folge von Amplituden-Differenzen aufeinanderfolgender Abtastwerte bzw. digital Bilddaten d entspricht. Die Verschiebung um eine halbe Periode c/2 des Basistakts c erfolgt, da der derart bestimmte Wert zeitlich einem Übergangszeitpunkt mittig zwischen zwei Bildpunkten entspricht. Die Verschiebung des Abtasttakts a erfolgt in zweckmäßiger Weise relativ zum horizontalen Synchronisationsimpuls.

Vorzugsweise sind der AD-Wandler ADC und die Datenphasen-Steuereinrichtung DPC sowie die Steuereinrichtung als individuelle oder ggf in einer Komponente kombinierte Hardware ausgebildet. Die Filter und Ableitungen werden hingegen bevorzugt softwaretechnisch durch die Steuereinrichtung C umgesetzt.

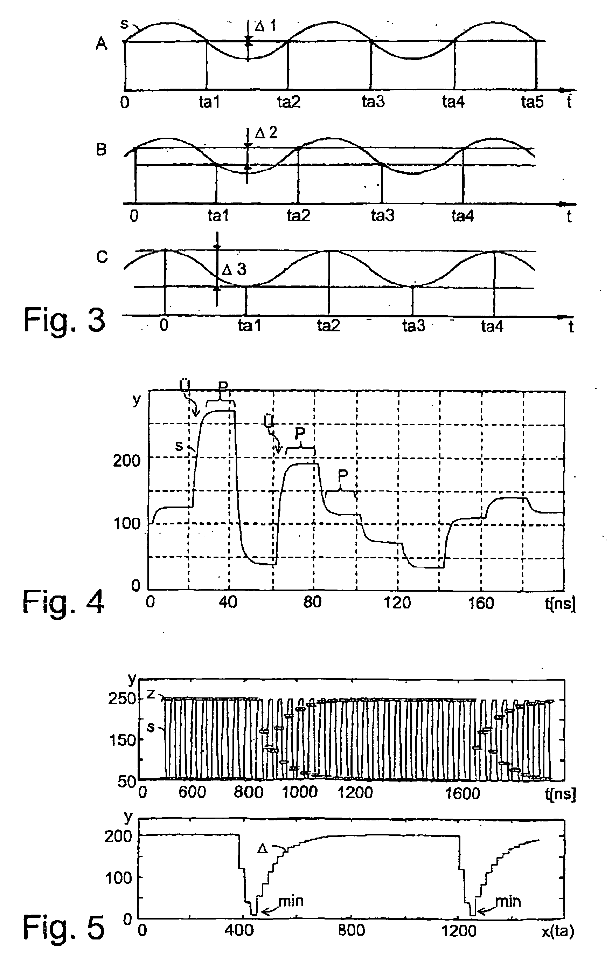

Fig. 3 zeigt drei Beispiele einer mit gleichem Abtasttakt a abgetasteten Sinusschwingung als einem beispielhaften analogen Bildsignal s über einer zeitachse t, wobei jede der Sinusschwingungen mit unterschiedlichen Phasenlagen abgetastet wird. Betrachtet werden die Amplitudendifferenzen Δ1, Δ2, Δ3 zwischen jeweils zwei aufeinanderfolgenden Sample- bzw. Abtastpunkten tal, ta2, ta3, ta4. Erkennbar ist, dass die Amplituden-differenzen Δ1, Δ2, Δ3 immer größer werden, je weiter sich die Abtastpunkte tal, ta2, ta3, ta4 vom Wendepunkt der Funktion der Sinusschwingung entfernen. Diese vorteilhafte Erkenntnis wird bei der verfahrensgemäßen Lösung ausgenutzt.

Angemerkt wird, dass eine Abtastfrequenz fa vorzugsweise genau der doppelten Signalfrequenz fs des analogen Bildsignals s bzw. der daraus abgetasteten digitalen Daten entspricht gemäß fa = 2*fs. Dieser Tatsache steht eigentlich das Abtasttheorem mit der Bedingung fa > 2*fs entgegen, wobei auch gerade dadurch eine möglichst ideale Einstellung der Abtastzeitpunkt erforderlich ist.

Anschaulich können die Sinusfunktionen als ein Schachbrett-Muster dargestellt werden mit abwechselnd schwarzen und weißen Bildpunkten, wobei die maximale Amplitude den Wert Weiß hat, die minimale Amplitude den Wert Schwarz hat und alle Amplituden in der Mitte dazwischen den Wert Grau haben. Ersichtlich ist, dass in den beiden ersten Diagrammen A, B ein entsprechendes Bild Grau abgebildet werden würde und erst im dritten Diagramm C ein Schwarz-Weiss-Muster abgebildet werden würde.

Das Ziel des bevorzugten Verfahrens liegt entsprechend darin, die Phasenlage zu finden, bei der die Amplitudendifferenzen Δ3 am größten sind. Dabei wird verfahrensgemäß jedoch zuerst mit einem ersten, umgekehrten Schritt begonnen: Zuerst wird nach der Phasenlage gesucht, bei der die Amplitudendifferenzen am kleinsten sind, was u.a. auch anhand der Fig. 4 und 5 veranschaulicht wird.

Fig. 4 zeigt einen typischen Verlauf eines Videosignals als einem analogen Signal s über der Zeitachse t, wie es von einer Grafikkarte geliefert wird. Dieses analoge Bildsignal s sieht nicht wie eine Sinusfunktion aus, sondern eher wie eine Lade- und Entlade-Kurve, wie sie von z.B. Kondensatoren bekannt sind. Sehr deutlich ist zu erkennen, dass das analoge Bildsignal s ein Plateau P hat, das sehr breit ist, und einen im Vergleich dazu schmalen Übergangsbereich Ü hat. Würde nun nach dem Maximum der Bildpunkt-Amplitudendifferenzen gesucht, würden über einen weiten Bereich ähnliche Resultate erzielt. Das Ergebnis wäre nicht eindeutig. Der Aufwand der entstehen würde, doch ein stabiles Resultat zu bekommen, wäre sehr groß. Hingegen ist es überraschend einfach, das Minimum der Amplitudendifferenzen zu finden. Dieses bietet den Vorteil, dass es ein eindeutiges Ergebnis liefert, wie aus Fig. 5 ersichtlich ist. Fig. 5 zeigt im oberen Diagramm Werte y von Abtastwerten z eines analogen Bildsignal s über der Zeitachse t. Diese Werte würden im Fall der beispielhaften Schwarz-Weiß-Abbildung wieder nur grau dargestellt werden.

Im unteren Diagramm von Fig. 5 sind entsprechende absolute Datenwerte y einer Delta-Funktion Δ über der um 400 ns verschobenen Zeitachse t skizziert. Im Fall der beispielhaften Schwarz-Weiß-Abbildung würde wieder ein Schachbrett-Muster dargestellt und eine daraus letztendlich entstehende Deltafunktion Δ, wenn der Abtastzeitpunkt nach und nach verschoben wird. Minima min der Delta-Funktion Δ sind eindeutig auszumachen.

Gemäß einem bevorzugten Verfahren zum Einstellen der Abtast-zeitpunkte ta kann aus einer beliebigen Position gestartet werden. D.h. der Abtasttakt a, der den oder die AD-Wandler ADC treibt, liegt in einer beliebigen Phasenlage zum analogen Bildsignal s. Nachfolgend werden alle Differenzen, die sich als Amplitudendifferenzen in einer bestimmten Zeile eines abzutastenden Bildes befinden, aufsummiert. Es wird also immer von zwei aufeinanderfolgenden Abtastwerten z die Amplitudendifferenz gebildet und zur vorhergehenden Differenzensumme dazu addiert. Diese Vorgehensweise hat den Vorteil, unempfindlicher gegen Rauschen und Messfehlern zu sein. Die Verfahrensweise beruht auf der Annahme, dass die Summe von im Mittel kleineren Differenzen kleiner ist, als die Summe von im Mittel größeren Differenzen.

Um trotzdem ein schnelles Ergebnis zu bekommen, wird vorzugsweise nicht ein ganzes abzutastendes Bild betrachtet, sondern nur eine repräsentative Zeile davon. Die Bewertung der Zeilen und das Auswählen einer geeigneten Zeile übernimmt ein intelligenter Sensor in Form der Datenphasen-Steuereinrichtung DPC (Fig. 1), welche auch Bestandteil einer übergeordneten Steuereinrichtung sein kann. Die Datenphasen-Steuereinrichtung DPC stellt vorzugsweise auch sicher, das in weiterer Folge immer die gleiche Zeile gemessen wird, um eine Referenz zu haben.

Wurde der erste Wert der Deltafunktion Δ erhalten, dann wird ein Bild später der Abtasttakt a um einen bestimmten Phasenbetrag dt verschoben. Diese Verschiebung wird z.B. mit Hilfe der Regeleinrichtung DLL durchgeführt. Damit lassen sich leicht diskrete Phasenwerte einstellen. Nach dem Messen der Zeile wird ein zweiter Funktionswert der Deltafunktion Δ erhalten. So wird vorzugsweise kontinuierlich weiter verfahren, bis der Abtasttakt a durch ein ganze Bildpunktperiode durchgeschoben wurde. Während der gesamten Messung wird festgestellt, an welcher Stelle bzw. in welcher Phasenlage sich das Minimum min der Deltafunktion Δ befindet.

Da die Bildpunktperiode und die Abtasttaktperiode (1/fa = 1/fc) gleich sind und der Abtasttakt a üblicherweise bekannt ist, kann der Abtasttakt a so verschoben werden, dass er genau eine halbe Periode c/2 bzw. a/2 versetzt zum Deltafunktionsminimum liegt und somit der ideale Abtastzeitpunkt ta eingestellt ist.

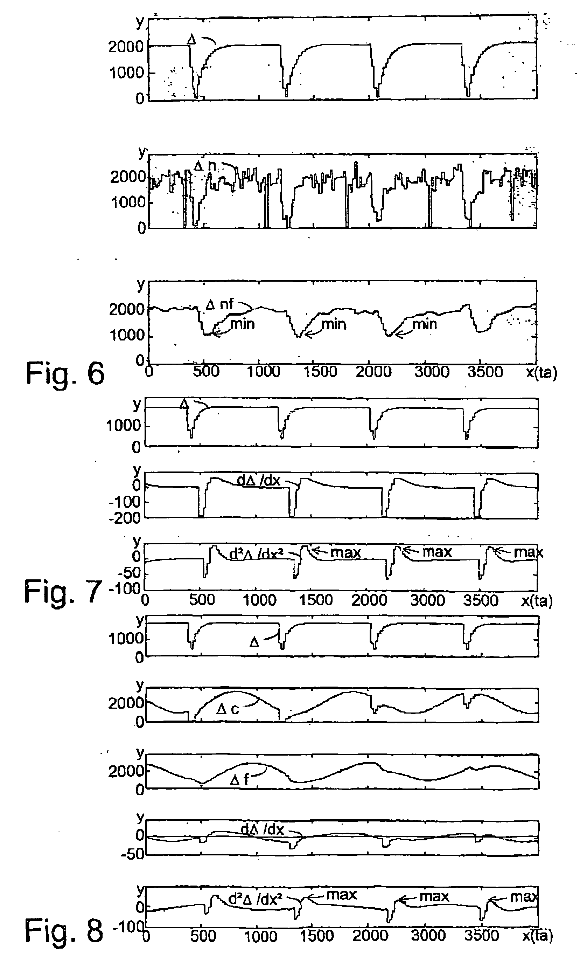

Da während der Messung Änderungen des Bildinhaltes und Messfehler allgemeiner Natur auftreten können, wird das Minimum vorzugsweise auf eine Art und Weise gesucht, welche anhand Fig. 1 und Fig. 6 veranschaulicht ist. Fig. 6 zeigt über den Abtastzeitpunkten ta bzw. über der Abfolge der Abtastwerte x akkumulierte Werte y dreier solche Deltafunktionen Δ. Die obere Deltafunktion Δ ist fehlerfrei. Die mittlere Deltafunktion Δn ist mit Rauschen und Messfehlern behaftet. Um das Rauschen zu dämpfen und die und Messfehler zu eliminieren wird ein Tiefpassfilter TPF1 und ein Medianfilter MFl verwendet. Die untere Delta-funktion Δf ist entsprechend gefiltert. Das Rauschen ist in diesem Beispiel übertrieben dargestellt, da es bereits eine integrierte Funktion ist. Trotzdem können die Minima min eindeutig bestimmt werden.

Ein komplexeres Problem besteht, wenn sich der Bildinhalt ändert. In diesem Fall ändert sich die Form der Deltafunktion Δ. Um trotzdem eine Aussage machen zu können, wo sich die Minima min befinden, wird die Deltafunktion zweimal abgeleitet, wie dies anhand der Fig. 1, 7 und 8 skizziert ist. Dargestellt sind in Fig. 7 über den Abtastzeitpunkten ta bzw. über der Abfolge der Abtastwerte x akkumulierte Werte y dreier Deltafunktionen Δ, wobei die mittlere Deltafunktion dΔ/dx der ersten Ableitung und die untere Deltafunktion d²Δ/dx² der zweiten Ableitung entspricht. Fig. 8 zeigt entsprechend von oben nach unten eine ungestörte Deltafunktion Δ, eine Deltafunktion Δc mit sich während der Messung änderndem Kontrast, eine gefilterte Deltafunktion Af, eine Deltafunktion dΔ/dx mit Ableitung erster Ordnung und eine Deltafunktion d²Δ/dx² mit Ableitung zweiter Ordnung.

Das Maximum max der zweiten Ableitung befindet sich an der Stelle, wo sich das Minimum min der Urspxungsiunktion befindet. Allerdings sind in dieser abgeleiteten Funktion störende Signalanteile herausgefallen. Wie aus Fig. 8 ersichtlich ist, können die Maxima max der zweiten Ableitung eindeutig den Minima min der Deltafunktion Δ zugeordnet werden. Die Verschiebung ergibt sich aufgrund des Rechenprozesses, ist statisch und kann kompensiert werden.

## Patentansprüche

1. Verfahren zum Einstellen von Abtast-Zeitpunkten (ta) eines Abtasttakts (a) in einem Bildsignal-Abtastsystem, bei dem
- ein analoges Bildsignal (s) bereitgestellt und mittels des Abtasttakts mit einer Abtast-Frequenz (fa = fc) zum Bereitstellen digitaler Bilddaten (d) abgetastet wird, wobei
- der Abtasttakt durch zeitliche Verschiebung (dt) aus einem Basistakt (c) zum Abtasten bereitgestellt wird und
- eine erforderliche zeitliche Verschiebung (dt) bestimmt wird aus den Bilddaten (d),
**dadurch gekennzeichnet, dass**
- eine Folge von Amplituden-Differenzen zwischen jeweils zumindest zwei Amplitudenwerten der Bilddaten (d) ermittelt wird,
- ein Minimum-Abtast-Zeitpunkt als Zeitpunkt der geringsten Amplituden-Differenz aus der Folge der Amplituden-Differenzen bestimmt wird und
- die zum Abtasten zu verwendenden Abtast-Zeitpunkte (ta) bestimmt werden aus dem Minimum-Abtast-Zeitpunkt zuzüglich der erforderlichen zeitlichen Verschiebung (dt) ungleich Null.

2. Verfahren nach Anspruch 1, bei dem die erforderliche zeitliche Verschiebung zwischen 1/3 und 2/3 einer Periode der Abtast-Frequenz (fa) beträgt.

3. Verfahren nach Anspruch 1 oder 2, bei dem die erforderliche zeitliche Verschiebung etwa 1/2 einer Periode, insbesondere genau 1/2 einer Periode der Abtast-Frequenz (fa) beträgt.

4. Verfahren nach einem vorstehenden Anspruch, bei dem zur Bestimmung des Minimum-Abtast-Zeitpunktes eine Mittelung über zueinander benachbarte Amplituden-Differenzen durchgeführt wird.

5. Verfahren nach einem vorstehenden Anspruch, bei dem die erforderliche zeitliche Verschiebung (dt) derart bestimmt wird, dass die Abtast-Zeitpunkte (ta) des Abtasttakts in einen Plateaubereich eines Bildpunktes fallen.

6. Verfahren nach einem vorstehenden Anspruch, bei dem die Bilddaten (d) vor dem Bestimmen des Minimum-Abtast-Zeitpunkts gefiltert werden, insbesondere mit einem Medianfilter und einem Tiefpassfilter gefiltert werden.

7. Verfahren nach einem vorstehenden Anspruch, bei dem die Abtast-Frequenz (fa) gleich oder gleich einem gerad- und ganzzahligen Vielfachen einer Bildfrequenz verwendet wird.

8. Verfahren nach einem vorstehenden Anspruch, bei dem die Amplituden-Differenzen gebildet werden aus jeweils zwei unmittelbar aufeinanderfolgenden Amplitudenwerten der Bilddaten (d).

9. Verfahren nach Anspruch 8, bei dem eine Vielzahl aufeinanderfolgender Amplituden-Differenzen aufsummiert wird.

10. Verfahren nach Anspruch 9, bei dem die Amplituden-Differenzen einer Zeile eines Bildes aufsummiert werden und mit aufsummierten werten derselben Zeile eines anderen Bildes verglichen werden.

11. Verfahren nach einem vorstehenden Anspruch, bei dem eine Δ-Funktion gebildet wird durch Erfassen eines ersten Differenzwertes als erstem Δ-Funktionswert und durch das jeweilige Verschieben des Abtasttaktes und Erfassen eines weiteren Differenzwertes als weiterem Δ-Funktionswert und bei dem der Minimum-Abtast-Zeitpunkt alternativ oder zusätzlich indirekt aus einem Minimum der Δ-Funktion bestimmt wird.

12. Verfahren nach Anspruch 11, bei dem der Minimum-Abtast-Zeitpunkt alternativ oder zusätzlich indirekt bestimmt wird über das Bestimmen eines Maximums einer zweiten Ableitung der Δ-Funktion, wobei die Δ-Funktion aus aufeinanderfolgenden Amplituden-Differenzen gebildet wird.

13. Schaltung zum Einstellen von Abtast-Zeitpunkten eines Abtasttakts (a) in einem Bildsignal-Abtastsystem, mit
- einem AD-Wandler (ADC), dem ein analoges Bildsignal (s) bereitgestellt und mittels des Abtasttakts mit einer Abtast-Frequenz (fa = fc) zum Bereitstellen digitaler Bilddaten (d) abgetastet wird, wobei
- Mittel vorgesehen sind, sodass der Abtasttakt durch zeitliche Verschiebung (dt) aus einem Basistakt (c) zum Abtasten bereitgestellt wird und
- Mittel zur Bestimmung einer erforderlichen zeitlichen Verschiebung (dt) aus den Bilddaten (d) vorgesehen sind,
**gekennzeichnet durch**
- Mittel zur Ermittlung einer Folge von Amplituden-Differenzen zwischen jeweils zumindest zwei Amplitudenwerten der Bilddaten (d)
- Mittel zur Bestimmung eines Minimum-Abtast-Zeitpunkts als Zeitpunkt der geringsten Amplituden-Differenz aus der Folge der Amplituden-Differenzen und
- Mittel zum Bestimmen der zum Abtasten zu verwendenden Abtast-Zeitpunkte (ta) aus dem Minimum-Abtast-Zeitpunkt zuzüglich der erforderlichen zeitlichen Verschiebung (dt) ungleich Null.

## Claims

1. A method for setting sampling times (ta) of a sampling clock (a) in an image signal sampling system, wherein
- an analogue image signal (s) is provided and is sampled by means of the sampling clock at a sampling frequency (fa = fc) for providing digital image data (d), wherein
- the sampling clock is provided by means of a time delay (dt) from a base clock (c) for sampling, and
- a required time delay (dt) is established from the image data (d),
**characterised in that**
- a sequence of amplitude differences is determined between each of at least two amplitude values of the image data (d),
- a minimum sampling time is established as the point in time with the lowest amplitude difference from the sequence of amplitude differences, and
- the sampling times (ta) used for sampling are established from the minimum sampling time plus the required time delay (dt) of non zero.

2. The method as claimed in Claim 1, wherein the required time delay is between 1/3 and 2/3 of a period of the sampling frequency (fa).

3. The method as claimed in Claim 1 or 2, wherein the required time delay is approximately 1/2 of a period, particularly exactly 1/2 of a period of the sampling frequency (fa).

4. The method as claimed in any one of the preceding claims, wherein for establishing the minimum sampling time, an averaging process over the amplitude differences which are adjacent to one another is carried out.

5. The method as claimed in any one of the preceding claims, wherein the required time delay (dt) is established in such a way that the sampling times (ta) of the sampling clock fall into a plateau region of a pixel.

6. The method as claimed in any one of the preceding claims, wherein the image data (d) are filtered prior to establishing the minimum sampling time, in particular filtered by means of a median filter or a low-pass filter.

7. The method as claimed in any one of the preceding claims, wherein the sampling frequency (fa) used is equal to an image frequency or equal to an even integer multiple of an image frequency.

8. The method as claimed in any one of the preceding claims, wherein the amplitude differences are each formed from two immediately successive amplitude values of the image data (d).

9. The method as claimed in Claim 8, wherein a plurality of successive amplitude differences are added up.

10. The method as claimed in Claim 9, wherein the amplitude differences of a line of an image are added up and are compared with the added-up values of the same line of another image.

11. The method as claimed in any one of the preceding claims, wherein a Δ function is formed by detecting a first difference value as the first Δ function value and is established by means of the respective delay of the sampling clock and by detecting a further difference value as a further Δ function value, and wherein the minimum sampling time is established alternatively or in addition indirectly from a minimum of the Δ function.

12. The method as claimed in Claim 11, wherein the minimum sampling time is alternatively or in addition indirectly determined via establishing a maximum of a second derivative of the Δ function, wherein the Δ function is formed from successive amplitude differences.

13. A circuit for setting sampling times of a sampling clock (a) in an image signal sampling system, including
- an AD converter (ADC) which is supplied with an analogue image signal (s) which is sampled by means of the sampling clock at a sampling frequency (fa = fc) for providing digital image data (d), wherein
- means are provided so that the sampling clock is provided by means of a time delay (dt) from a base clock (c) for sampling, and
- means for establishing a required time delay (dt) from the image data (d) are provided,
**characterised by**
- means for determining a sequence of amplitude differences between each of at least two amplitude values of the image data (d),
- means for establishing a minimum sampling time as the point in time of the lowest amplitude difference from the sequence of the amplitude differences, and
- means for establishing the sampling times (ta) used for sampling from the minimum sampling time plus the required time delay (dt) of non zero.

## Revendications

1. Procédé pour régler les instants d'échantillonnage (ta) d'une cadence d'échantillonnage (a) dans un système d'échantillonnage de signaux d'image, dans lequel on prépare :
- un signal d'image (s) analogique et on l'échantillonne au moyen d'une cadence d'échantillonnage avec une fréquence d'échantillonnage (fa = fc) pour préparer des données d'image (d) numériques, dans lequel
- la cadence d'échantillonnage est préparée pour l'échantillonnage par un décalage dans le temps (dt) à partir d'une période de base (c), et
- un décalage dans le temps (dt) nécessaire est déterminé à partir des données image (d),
**caractérisé en ce que**
- on détermine une suite de différences d'amplitude entre à chaque fois au moins deux valeurs d'amplitude des données d'image (d),
- on détermine un instant d'échantillonnage minimum en tant qu'instant de la plus faible différence d'amplitude à partir de la suite des différences d'amplitude, et
- les instants d'échantillonnage (ta) utilisés pour l'échantillonnage sont déterminés à partir de l'instant d'échantillonnage minimum augmenté du décalage dans le temps (dt) nécessaire, différent de zéro.

2. Procédé selon la revendication 1,
selon lequel
le décalage dans temps nécessaire se situe entre 1/3 et 2/3 d'une période de la fréquence d'échantillonnage (fa).

3. Procédé selon la revendication 1 ou 2,
selon lequel
le décalage dans le temps nécessaire est d'environ 1/2 période et en particulier exactement une 1/2 période de la fréquence d'échantillonnage (fa).

4. Procédé selon l'une des revendications précédentes,
selon lequel
pour déterminer l'instant d'échantillonnage minimum, on calcule une moyenne de différences d'amplitude voisines.

5. Procédé selon l'une des revendications précédentes,
selon lequel
le décalage dans le temps (dt) nécessaire, est déterminé de sorte que les instants d'échantillonnage (ta) de la cadence d'échantillonnage se trouvent dans une zone de plateau d'un point image.

6. Procédé selon l'une des revendications précédentes,
selon lequel
les données image (d) sont filtrées avant la détermination de l'instant d'échantillonnage minimum, en particulier avec un filtre médian et un filtre passe-bas.

7. Procédé selon l'une des revendications précédentes,
selon lequel
la fréquence d'échantillonnage (fa) utilisée est un multiple égale à la fréquence d'image, paire et entier d'une fréquence d'image.

8. Procédé selon l'une des revendications précédentes,
selon lequel
les différences d'amplitude sont calculées à partir à chaque fois de deux valeurs d'amplitude se suivant directement dans les données image (d).

9. Procédé selon la revendication 8,
selon lequel
on additionne un grand nombre de différences d'amplitude consécutives.

10. Procédé selon la revendication 9,
selon lequel
les différences d'amplitudes d'une ligne d'une image, sont additionnées et sont comparées avec des valeurs additionnées de la même ligne d'une autre image.

11. Procédé selon l'une des revendications précédentes,
selon lequel
on forme une fonction Δ par la saisie d'une première valeur de différence en tant que première valeur de fonction Δ et par le décalage correspondant de la cadence d'échantillonnage et la saisie d'une autre valeur de différence comme autre valeur de la fonction Δ et dans lequel l'instant d'échantillonnage minimum est déterminé de manière alternative ou complémentaire indirectement à partir d'un minimum de la fonction Δ.

12. Procédé selon la revendication 11,
selon lequel
l'instant d'échantillonnage minimum est déterminé alternativement ou complémentairement indirectement par la détermination d'un maximum d'une dérivée seconde de la fonction Δ, la fonction Δ étant formée à partir de différences d'amplitude consécutives.

13. Circuit pour régler des instants d'échantillonnage d'une cadence d'échantillonnage (a) dans un système d'échantillonnage de signaux d'image, comprenant :
- un convertisseur analogique/numérique (AD)/(ADL) auquel on fournit un signal d'image analogique (s) et on échantillonne au moyen d'une cadence d'échantillonnage avec une fréquence d'échantillonnage (fa = fc) pour préparer des données d'image (d) numériques,
circuit comprenant :
- des moyens pour préparer la cadence d'échantillonnage par un décalage dans le temps (dt) à partir d'une cadence de base (c) pour l'échantillonnage, et
- des moyens pour déterminer un décalage dans le temps (dt) nécessaire à partir des données d'image (d),
**caractérisé par**
- des moyens pour déterminer une suite de différences d'amplitude entre chaque fois au moins deux valeurs d'amplitude des données d'image (d),
- des moyens pour déterminer un instant d'échantillonnage minimum comme instant de la plus faible différence d'amplitude à partir de la suite des différences d'amplitude, et
- des moyens pour déterminer l'instant d'échantillonnage (ta) à utiliser pour l'échantillonnage à partir de l'instant d'échantillonnage minimum augmenté du décalage dans le temps (dt) nécessaire différent de zéro.
